# EUROPEAN PATENT SPECIFICATION

(11) **EP 2 960 658 B1**
(45) Date of publication and mention of the grant of the patent: **27.09.2017**
(21) Application number: 14174105.8
(22) Date of filing: 26.06.2014
(51) Int. Cl.: G01R 1/073, G01R 3/00, B23H 7/02, H01R 43/16, H01R 43/20

(54) **Method of manufacturing a contactor body**
Verfahren zur Herstellung eines Schützkörpers
Procédé de fabrication d'un corps de contacteur

(43) Date of publication of application: 30.12.2015
(73) Proprietor: Rasco GmbH, 83059 Kolbermoor (DE)
(72) Inventor: Croce, Karl, 83334 Inzell (DE); Thaller, Gerhard, 83556 Griesstätt (DE)
(74) Representative: Grünecker Patent- und Rechtsanwälte PartG mbB

(56) References cited:
- JP-A- 2009 008 450
- US-A1- 2004 157 350
- US-A1- 2005 258 844

## Description

### Field of the Invention

The present invention relates to a method of manufacturing a contactor body / socket for testing semiconductor devices / integrated circuit components.

### Prior Art

For testing the quality of semiconductor devices, for example integrated circuits components (ICs), the ICs are brought into contact with a contactor body of an automatic test system to verify their function. Based on the test results, the ICs may be sorted to make them available for packaging or other applications. To do so, contactor bodies are needed that have contacting tips which contact the corresponding contact areas of an IC. Test signals are send via the contactor body and the contactor tips to the IC and response signals are received in return.

These contactor bodies are manufactured according to the prior art by forming individual contactor elements and thereafter placing them in a socket. This has to be done with a sufficient accuracy, in particular such that the contactor tips can contact the contacting areas / contacting points of the ICs at the same time. Although each contactor element is formed such that the end portions thereof with the contacting tip have a spring characteristic within a predefined range of contact force, however, it has turned out that spread in contacting force due to minute differences of the position of the contactor tips may lead to wrong test results, specifically when abrasion of material leads to increased contact resistance such that contacting sites with relatively smaller contacting forces may fail. An alternative to the traditional prior art techniques of forming individual contactor elements is found in US 2005/258844 A1. US 2005/258844 A1 discloses a freely deflecting knee probe with controlled scrub motion. In US 2005/258844 A1, a number of probes can be simultaneously fabricated as a probe comb; the probe comb is held together by a probe bridge; a number of probe combs are stacked forming 2-dimensional probe arrays; and after positioning the probe combs with respect to each other, they may be fixed and, thereafter, the probe bridges are removed.

This is disadvantageous and causes problems because of dead time of the testing apparatus for cleaning purposes or for replacing the contactor bodies.

### Description of the Invention

The problem underlying the present invention in view of the prior art is to provide a method of manufacturing a contactor body that is more reliable and/or that has an increased operation period and a contactor body manufactured according to the method of the invention.

The above-mentioned problem is solved by the method according to claim 1.

The invention provides a method of manufacturing a contactor body having contact tips configured for temporarily contacting respective contact areas of a semiconductor device, in particular a die, a wafer or an integrated circuit component, the method of manufacturing the contactor body comprising the steps of stacking a plurality of semi-finished contactor elements to form a stack, wherein each of the semi-finished contactor elements is formed of an electrically conductive material; and the step of simultaneously shaping the semi-finished contactor elements in the stack to form portions of respective shaped contactor elements having the respective contact tips of the contactor body.

This method according to the invention has the advantage that a fixed stack of semi-manufactured element is formed first, and thereafter the whole stack is finished to form at the same time the final form of the contacting elements, in particular with the regions including the contacting tips. Accordingly, the precise forming of the contact tips is performed in exactly the same way for all contactor elements. Therefore, during operation of the contactor body in a testing apparatus for testing ICs, the force, specifically the spring force, between the contact tips and the corresponding contact areas of an IC will be much more homogeneous, i.e., with a reduced variation, than according to the prior art method of manufacturing a contactor body.

The inventive method can be developed such that the step of simultaneously shaping the stacked plurality of semifinished contactor elements may comprise electrical discharge machining the stacked plurality of semifinished contactor elements simultaneously. This is a particularly efficient and exact way of shaping the semifinished contactor elements. Although the method of electrical discharge machining as such is know in the art and is also called synonymously as spark machining, spark eroding, wire cutting, and wire erosion, it has turned out that this method of forming the contact tips is preferable over other methods that are possible, in principle, for example Laser cutting. The latter, however, may lead to small but constantly increasing offsets of the position of the contact tips due to laser beam divergence. Electrical discharge machining such as wire cutting has the advantage that during the process of forming the contact tips no or only a very small mechanical force is applied to the semifinished contactor elements in the stack, with the consequence that displacements, twisting and stresses are avoided.

According to another development, the step of stacking the plurality of semifinished contactor elements may further comprise the step of permanently fixing the stacked plurality of semifinished contactor elements, in particular by adhesion. This has the advantage that the contactor elements are already permanently fixed before the contact tips are formed, such that the whole assembly of contactor elements thereafter be easily handled without risk of accidental displacement of the individual parts.

In a further development the step of stacking the plurality of semifinished contactor elements may comprise the step of placing the plurality of semifinished contactor elements in a base body. This has the advantage that a base body that is pre-formed can be used to fix the stack of semifinished contactor elements. Specifically, the base body may be configured to fit into a testing site of a particular IC testing apparatus. Further, such base bodies including the stack of semifinished contactor elements may be manufactured and stored. The step of shaping the contact tips may be performed at later point in time and the desired characteristic of the contact tips may then be realized. These characteristics may include spring characteristics such as elastic force, the exact position of the contact tips and the range of movement of the contact tips during contacting the contact areas of the semiconductor device, in particular perpendicular to movement in the contacting direction.

According to a preferred development thereof, the step of placing the plurality of semifinished contactor elements in the base body may comprise the step of placing each of the plurality of semifinished contactor elements in respective preformed reception regions of the base body. This allows for easy placing the semifinished contactor elements in the base body.

It is moreover preferred that the preformed reception regions of the base body are spaced such that neighbouring contactor elements are not in contact with each other, in particular, wherein neighbouring preformed reception regions of the base body are spaced from each other with a constant spacing. This has the advantage that further provisions to electrically isolate the contactor elements from each other are not required.

Alternatively or additionally, the step of stacking the plurality of semifinished contactor elements may comprises the step of alternately stacking the plurality of semifinished contactor elements with spacing elements, in particular, wherein the spacing elements are formed of a material that is not electrically conductive. This isolates the contactor elements from each while being in a fixed position relative to each other in the stack. According to another development, the step of stacking the plurality of semifinished contactor elements may comprise stacking the plurality of semifinished contactor elements in electrical contact with each other, in particular in direct contact with each other. This is useful in case the semiconductor device has a relatively larger contact area that shall be contacted by the plurality of contact tips simultaneously. Further, if the contact area is not planar an electrical contact is provided with at least one or some of the plurality of contact tips.

According to another development, the material of the contactor elements may provide mechanical spring characteristics to the portions of the respective shaped contactor elements having the respective contact tips. This has the advantage that possibly still remaining differences in the positions of the contact tips can be adjusted by minute deformations of the portions of the respective shaped contactor elements having the respective contact tips during contacting corresponding contact areas / contact points of an IC.

In another development each semifinished contactor element may be formed from a sheet element. This has the advantage that the contactor elements can be easily stacked due to the two plane sides of each sheet or plate-like element.

The above-mentioned problem is further solved by the contactor body according to claim 9. Therefore, the invention further provides a contactor body having contact tips configured for temporarily contacting respective contact areas of a semiconductor device, the contactor body being manufactured according to the method of the invention or according to one or more of its developments. The contactor body comprises shaped contactor elements having respective contact tips of the contactor body, wherein each of the contactor elements is formed of an electrically conductive material.

Further features and advantages of the present invention will be described in the following with reference to the figures, which illustrate only examples of embodiments of the present invention. The illustrated and described features may be suitably combined with each other.

### Brief Description of the Drawings

Fig. 1 illustrates an embodiment of the method according to the invention.
Fig. 2A-D illustrate components involved in the manufacturing of a contactor body according to the method of the invention.

### Description of the Embodiments

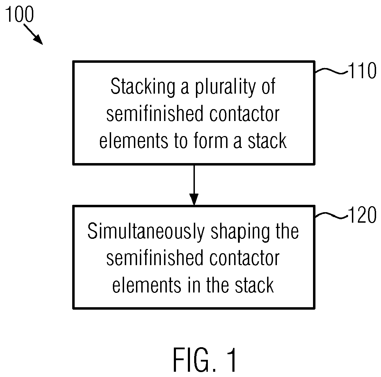

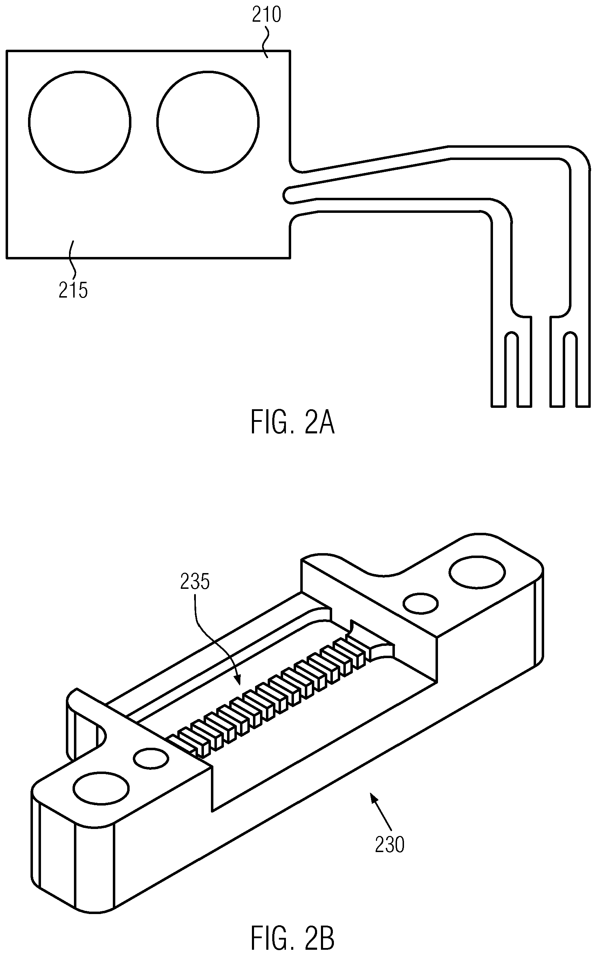

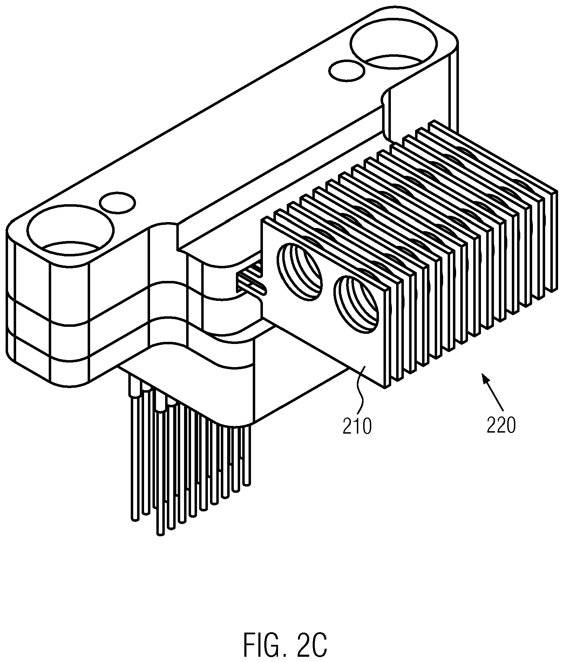

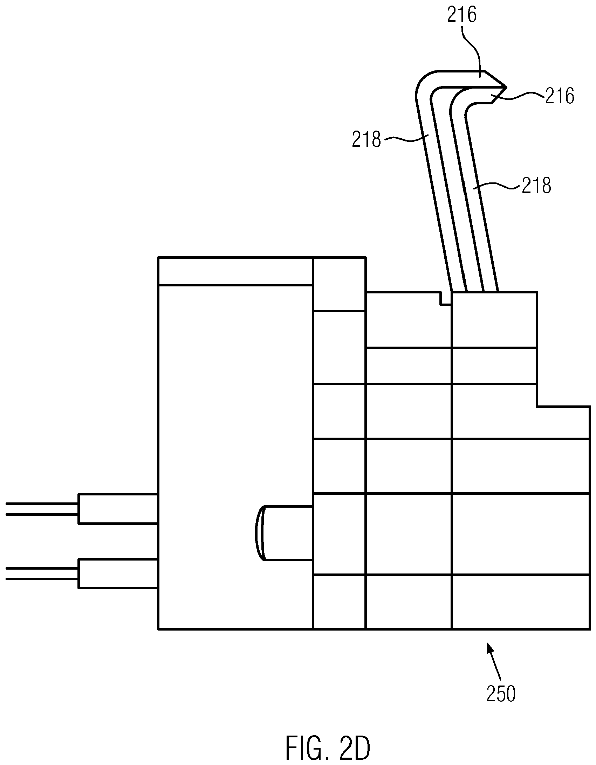

Figure 1 shows an embodiment of the inventive method 100. Figures 2A, B, C, D illustrate components involved in the manufacturing of a contactor body according to the method of the invention. The invention provides a method 100 of manufacturing a contactor body 250 having contact tips 216 configured for temporarily contacting respective contact points of integrated circuit components.

In this embodiment of the method 100 according to the invention, the first step 110 is the step of stacking a plurality of semifinished contactor elements 210 to form a stack 220. Each of the semifinished contactor elements 210 is formed of an electrically conductive material. For example, this material may comprise hardened CuBe. The second step 120 is the step of simultaneously shaping the semi-finished contactor elements 210 in the stack 220 to form portions 215 of respective shaped contactor elements 210 having the respective contact tips 216 of the contactor body 250.

The step 110 of stacking the plurality of semifinished contactor elements 210 according to this embodiment involves the step of placing the plurality of semifinished contactor elements 210 in a base body 230. This has the advantage that a base body 230 that is pre-formed can be used to fix the stack 220 of semifinished contactor elements 210. Specifically, the base body 230 may be configured to fit into a testing site of a particular IC testing apparatus. Further, the plurality of semifinished contactor elements 210 is preferably placed in respective preformed reception regions 235 of the base body 230.

The step 110 of simultaneously shaping the stacked plurality of semifinished contactor elements 210 is in this embodiment performed by using electrical discharge machining of the stacked plurality of semifinished contactor elements 210 simultaneously, i.e. by wire eroding, typically performed by submerging the workpiece, the stack 220 in the present case, in an insulating liquid such as oil, while an electrode and the workpiece are connected to a power supply generating a voltage between the electrode and the workpiece. When the electrode is close to the workpiece, dielectric breakdown in the liquid causes a plasma channel with sparks to be generated.

This method has the advantage that a fixed stack 220 of semi-manufactured element 210 is formed first, and thereafter the whole stack 220 is finished to form at the same time the final form of the contacting elements 218, in particular with the regions including the contacting tips 216. Accordingly, the precise forming of the contact tips 216 is performed in exactly the same way for all contactor elements. Therefore, during operation of the contactor body 250 in a testing apparatus for testing ICs, the force, specifically the spring force, between the contact tips 216 and the corresponding contact points of an IC will be homogeneous with a reduced variation, than according to the prior art method of manufacturing a contactor body.

Moreover, the semifinished contactor elements in the stack are fixed at the same location points (e.eg. boreholes) as they are fixed in the final contactor body used for contacting the contact areas of the semiconductor devices. Therefore, the chain of tolerances (imprecision) during production of the contactor bodies can be shortened as compared to the prior art production method.

The embodiments describe the invention by way of example only, while the full scope of the invention is defined by the claims.

## Claims

1. Method of manufacturing a contactor body (250) having contact tips (216) configured for temporarily contacting respective contact areas of a semiconductor device, the method of manufacturing the contactor body comprising the steps of:
stacking (110) stocking a plurality of semifinished contactor elements (210) to form a stack (220) comprising placing the plurality of semifinished contactor elements in a base body (230) of the contactor body, each of the semifinished contactor elements being formed of an electrically conductive material and formed from a sheet element; and
after the step of stacking, finishing the stack by simultaneously shaping (120) the plurality of semifinished contactor elements in the stack to form portions of respective shaped contactor elements (218) having the respective contact tips (216) of the contactor body.

2. The method of claim 1, wherein the step of simultaneously shaping the stacked plurality of semifinished contactor elements comprises:
electrical discharge machining the stacked plurality of semifinished contactor elements simultaneously.

3. The method of claim 1 or 2, wherein the step of stacking the plurality of semifinished contactor elements further comprises:
permanently fixing the stacked plurality of semifinished contactor elements, in particular by adhesion.

4. The method of one of claims 1 to 3, wherein the step of placing the plurality of semifinished contactor elements in the base body comprises:
placing each of the plurality of semifinished contactor elements in respective preformed reception regions (235) of the base body.

5. The method of claim 4, wherein the preformed reception regions of the base body are spaced such that neighbouring contactor elements are not in contact with each other, in particular, wherein neighbouring preformed reception regions of the base body are spaced from each other with a constant spacing.

6. The method of one of claims 1 to 5, wherein the step of stacking the plurality of semifinished contactor elements comprises:
alternately stacking the plurality of semifinished contactor elements with spacing elements, in particular, wherein the spacing elements are formed of a material that is not electrically conductive.

7. The method of one of claims 1 to 3, wherein the step of stacking the plurality of semifinished contactor elements comprises:
stacking the plurality of semifinished contactor elements in electrical contact with each other, in particular in direct contact with each other.

8. The method of one of claims 1 to 7, wherein the material of the contactor elements provides mechanical spring characteristics to the portions of the respective shaped contactor elements having the respective contact tips.

9. Contactor body (250) having a base body (230) and contact tips (216) configured for temporarily contacting respective contact areas of a semiconductor device, the contactor body being manufactured according to the method of one of claims 1 to 8.

## Patentansprüche

1. Verfahren zur Herstellung eines Schützkörpers (250) mit Kontaktspitzen (216), die dazu konfiguriert sind, temporär mit jeweiligen Kontaktbereichen einer Halbleitervorrichtung in Kontakt zu kommen, wobei das Verfahren zur Herstellung eines Schützkörpers folgende Schritte umfasst:
Stapeln (110) einer Vielzahl von halbfertigen Schützelementen (210), um einen Stapel (220) zu bilden, umfassend das Platzieren der Vielzahl von halbfertigen Stützelementen in einem Basiskörper (230) des Schützkörpers, wobei jedes der halbfertigen Schützelemente aus einem elektrisch leitfähigen Material besteht und aus einem Plattenelement geformt ist;
nach dem Schritt zum Stapeln, Fertigbearbeiten des Stapels durch gleichzeitiges Formen (120) der Vielzahl von halbfertigen Schützelementen in dem Stapel, um Teile von jeweiligen geformten Schützelementen (218) zu bilden, welche jeweils Kontaktspitzen (216) des Schützkörpers aufweisen.

2. Verfahren nach Anspruch 1, wobei der Schritt zum gleichzeitigen Formen der gestapelten Vielzahl von halbfertigen Schützelementen umfasst:
funkenerosives Bearbeiten der gestapelten Vielzahl von halbfertigen Schützelementen gleichzeitig.

3. Verfahren nach Anspruch 1 oder 2, wobei der Schritt zum Stapeln der Vielzahl von halbfertigen Schützelementen des Weiteren umfasst:
permanentes Fixieren der gestapelten Vielzahl von halbfertigen Schützelementen, insbesondere durch Kleben.

4. Verfahren nach einem der Ansprüche 1 bis 3, wobei der Schritt zum Platzieren der Vielzahl von halbfertigen Schützelementen in dem Basiskörper umfasst:
Platzieren von jedem der Vielzahl von halbfertigen Schützelementen in jeweiligen geformten Aufnahmeregionen (235) des Basiskörpers.

5. Verfahren nach Anspruch 4, wobei die vorgeformten Aufnahmeregionen des Basiskörpers einander beabstanden, so dass benachbarte Schützelemente nicht miteinander in Kontakt kommen, wobei benachbarte vorgeformte Aufnahmeregionen einander insbesondere mit konstantem Abstand beabstanden.

6. Verfahren nach einem der Ansprüche 1 bis 5, wobei der Schritt zum Stapeln der Vielzahl von halbfertigen Schützelementen umfasst:
abwechselndes Stapeln der Vielzahl von halbfertigen Schützelementen mit Distanzelementen, wobei die Distanzelemente insbesondere aus einem Material bestehen, das nicht elektrisch leitfähig ist.

7. Verfahren nach einem der Ansprüche 1 bis 3, wobei der Schritt zum Stapeln der Vielzahl von halbfertigen Schützelementen umfasst:
Stapeln der Vielzahl von halbfertigen Schützelementen, so dass sie miteinander in elektrischem Kontakt stehen, und insbesondere in direktem Kontakt miteinander stehen.

8. Verfahren nach einem der Ansprüche 1 bis 7, wobei das Material der Schützelemente den Teilen der jeweiligen geformten Schützelemente, welche die jeweiligen Kontaktspitzen aufweisen, mechanische Federeigenschaften verleiht.

9. Schützkörper (250) mit einem Basiskörper (230) und Kontaktspitzen (216), die dazu konfiguriert sind, temporär mit jeweiligen Kontaktbereichen einer Halbleitervorrichtung in Kontakt zu kommen, wobei der Schützkörper gemäß dem Verfahren nach einem der Ansprüche 1 bis 8 hergestellt wird.

## Revendications

1. Un procédé de manufacture d'un corps de contacteur (250) possédant des pointes de contact (216) configurées pour temporairement contacter les surfaces de contact respectives d'un dispositif semi-conducteur, le procédé de manufacture du corps de contacteur comprenant les étapes de:
empilement (110) d'une pluralité d'éléments de contacteur semi-finis (210) pour former une pile (220) comprenant le placement de la pluralité d'éléments de contacteur semi-finis dans un corps de base (230) du corps de contacteur, chacun des éléments de contacteur semi-fini étant formé d'un matériau électro-conducteur et formé d'un élément en feuille; et
après l'étape d'empilement, la finition de la pile par la mise en forme simultanément (12) de la pluralité d'éléments de contacteur semi-finis dans la pile pour former des portions d'éléments de contacteur formés respectifs (218) possédant les pointes de contact respectives (216) du corps de contacteur.

2. Le procédé de la revendication 1, dans lequel l'étape de la mise en forme simultanément de la pluralité empilée d'éléments de contacteur semi-finis comprends:
un usinage par décharge électrique de la pluralité empilée d'éléments de contacteur semi-finis simultanément.

3. Le procédé de la revendication 1 ou 2, dans lequel l'étape d' empilement de la pluralité d'éléments de contacteur semi-finis comprends en outre:
la fixation de manière permanente de la pluralité empilée d'éléments de contacteur semi-finis, en particulier par adhésion.

4. Le procédé de l'une des revendication 1 à 3, dans lequel l'étape de placement de la pluralité d'éléments de contacteur semi-finis dans le corps de base comprends:
le placement de chacun de la pluralité d'éléments de contacteur semi-finis dans les zones de réception préformées respectives (235) du corps de base.

5. Le procédé de la revendication 4, dans lequel les zones de réception préformées du corps de base sont espacées afin que les éléments de contacteur voisins ne soient pas en contact les uns avec les autres, en particulier, dans lequel les zones de réception préformées voisines du corps de base sont espacées les unes des autres avec un espacement constant.

6. Le procédé de l'une des revendications 1 à 5, dans lequel l'étape d'empilement de la pluralité d'éléments de contacteur semi-finis comprends:
l'empilement alternatif de la pluralité d'éléments de contacteur semi-finis avec les éléments d'espacement, en particulier, dans lequel les éléments d'espacements sont formés d'un matériel qui n'est pas électro-conducteur.

7. Le procédé de l'une des revendications 1 à 3, dans lequel l'étape d'empilement de la pluralité des éléments de contacteur semi-finis comprends:
l'empilement de la pluralité d'éléments de contacteur semi-finis en contact électrique les uns avec les autres, en particulier en contact direct les uns avec les autres.

8. Le procédé de l'une des revendications 1 à 7, dans lequel le matériel des éléments contacteurs fournit les caractéristiques de ressort mécanique aux portions des éléments de contacteur formés respectifs possédant les pointes de contact respectives.

9. Le corps de contacteur (250) possédant un corps de base (230) et des pointes de contact (216) configuré pour temporairement contacter les surfaces de contact respectives d'un dispositif semi-conducteur, le corps de contact étant manufacturé selon le procédé de l'une des revendications 1 à 8.
